# FASCICULE DE BREVET EUROPEEN

(11) **EP 1 684 003 B1**
(45) Date de publication et mention de la délivrance du brevet: **10.09.2008**
(21) Numéro de dépôt: 06290111.1
(22) Date de dépôt: 17.01.2006
(51) Int. Cl.: F21S 8/10, F21V 19/00, H05K 1/18

(54) **Procédé de fixation sur une pièce tridimensionnelle d'un support électronique flexible supportant au moins une diode électroluminescente**
Befestigungsverfahren einer biegsamen Leiterplatte, die mindestens eine Leuchtdiode trägt, an einem dreidimensionalen Bauteil
Method for fastening a flexible printed circuit board, which supports at least one LED, to a three-dimensional element

(30) Priorité: 21.01.2005 FR 0500670
(43) Date de publication de la demande: 26.07.2006
(73) Titulaire: VALEO VISION, 93012 Bobigny Cedex (FR)
(72) Inventeur: Gasquet, Jean-Claude, 89100 Saint Clement (FR); Tanghe, Alcina, 77000 Melun (FR)

(56) Documents cités:
- EP-A- 1 247 690
- DE-A1- 10 234 995
- DE-A1- 10 254 662
- DE-A1- 19 507 234
- US-A1- 2003 020 192

## Description

### DOMAINE TECHNIQUE DE L'INVENTION

La présente invention a pour objet un procédé de fixation, sur une pièce optique tridimensionnelle, d'un support électronique flexible, appelé flexboard, supportant au moins une diode électroluminescente, ou LED. Elle a également pour objet un élément radiateur particulier intervenant dans un tel procédé de fixation. L'invention a essentiellement pour but de proposer une solution simplifiée pour assembler une pièce, ou partie, optique tridimensionnelle - par exemple un réflecteur, un écran, un masque, ou toute pièce susceptible de servir de pièce de fixation au sein d'un dispositif projecteur d'éclairage ou d'un dispositif de signalisation - et une pluralité de sources lumineuses de type diodes électroluminescentes, accompagnées notamment d'éléments radiateurs, tout en réduisant les coûts afférents audit procédé d'assemblage et en procurant des avantages en terme de photométrie et de style du dispositif projecteur auquel est destiné l'assemblage résultant.

Le domaine de l'invention est, d'une façon générale, celui des projecteurs d'éclairage, des dispositifs de signalisation et d'éclairage intérieur de véhicule automobile. Dans ce domaine, on connaît différents types de systèmes optiques, parmi lesquels on trouve essentiellement :
- des feux de position, d'intensité et de portée faible ;
- des feux de croisement, ou codes, d'intensité plus forte et de portée sur la route avoisinant 70 mètres ;
- des feux de route longue portée, et des feux de complément de type longue portée, dont la zone de vision sur la route avoisine 200 mètres ;
- des projecteurs perfectionnés, dits bimodes, qui cumulent les fonctions de feux de croisement et de feu de route en incorporant un cache amovible ;
- des projecteurs anti-brouillard ;
- des feux de signalisation tels qu'indicateurs de changement de direction, des feux de stop, de recul, des lanternes ;
- des feux de position, d'intensité et de portée faible ;
- des systèmes d'éclairage intérieur s'appuyant sur l'utilisation des diodes électroluminescentes émettant de la lumière blanche ou colorée associées à des matières plastiques transparentes (par exemple des guides de lumière).

Pour l'ensemble de ces produits, traditionnellement, on utilise des sources lumineuses de type lampes, à filament, halogènes, ou lampes à décharge. Mais depuis quelques années, les équipementiers automobiles ont proposé l'utilisation de diodes électroluminescentes, notamment pour les feux de signalisation, de type feux clignotants, ou pour les feux arrière. Les diodes électroluminescentes présentent un certain nombre d'avantages :
- tout d'abord, depuis longtemps, on sait que ce type de diodes ne rayonne pas de façon omnidirectionnelle, mais rayonne dans un demi espace opposé à un substrat qui supporte la jonction P-N de la diode considérée ; ainsi, en utilisant un rayonnement plus directif que les lampes halogènes, ou à décharge, de l'état de la technique, la quantité d'énergie perdue est moins importante qu'avec les lampes à décharge ou halogènes ;
- ensuite, on a récemment perfectionné ces diodes en terme d'intensité de rayonnement ; elles peuvent désormais rayonner un flux d'environ 100 lumens. De plus, les diodes fabriquées émettent un rayonnement depuis longtemps dans le rouge, mais désormais également dans le blanc, ce qui accroît le champ de leurs utilisations envisageables. La quantité de chaleur qu'elles dégagent est relativement limitée, et un certain nombre de contraintes, liées à la dissipation de la chaleur dans les dispositifs projecteurs de l'état de la technique, disparaissent ;
- enfin, les diodes consomment moins d'énergie, même à intensité de rayonnement égal, que les lampes à décharge ou les lampes halogènes ; elles sont peu encombrantes, et leur forme particulière offre des possibilités nouvelles pour la réalisation et la disposition des surfaces complexes qui leur sont associées.

### ARRIERE-PLAN TECHNOLOGIQUE DE L'INVENTION

De plus en plus, notamment pour répondre à des critères esthétiques souhaités par les constructeurs automobiles, on cherche à disposer tridimensionnellement, au sein d'un même dispositif projecteur, plusieurs diodes électroluminescentes : au sein d'un dispositif projecteur donné, différentes leds, éventuellement de différents types, sont disposées sur des plans de support différents ; en d'autres termes, une pièce optique tridimensionnelle est destinée à recevoir et maintenir une pluralité de sources lumineuses dans des plans différents.

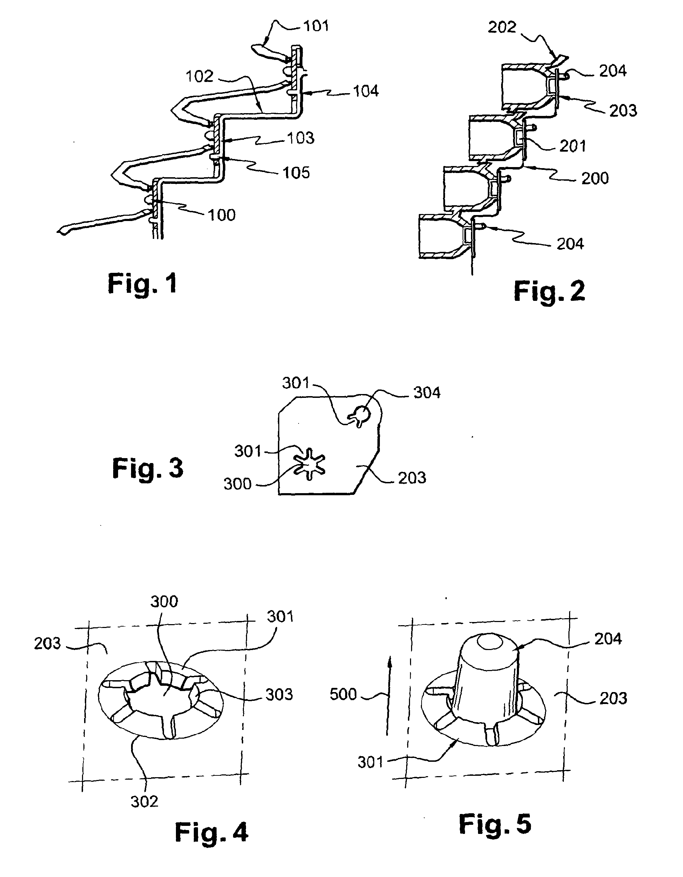

Les solutions existantes pour de telles juxtapositions consistent, dans le cas des leds, essentiellement à utiliser des supports électroniques rigides, connus de l'homme du métier, de type substrats CEM1, FR4, SMI, MCPCB ou autres, ou éventuellement des supports électroniques flexibles, pour supporter les différentes sources lumineuses. L'utilisation des supports électroniques rigides présente notamment des inconvénients en terme d'interconnexion des différents substrats. L'utilisation des supports électroniques flexibles est avantageuse du fait de leur caractère souple : on peut les plier aisément pour les placer tridimensionnellement sur une pièce optique de forme quelconque. Le document DE 102 54 662 montre de tels supports electroniques flexibles montés dans un feu de véhicule. Une solution fréquemment utilisée pour réaliser une mise en place de diodes électroluminescentes dans un environnement tridimensionnel est décrite en se référant à la figure 1.

Sur cette figure, une pluralité de diodes électroluminescentes 100 sont positionnées dans un réflecteur tridimensionnel 101, montré en coupe à la figure 1. Le procédé de fixation de l'état de la technique illustré ici est le suivant :

Dans un premier temps, un flexboard 102 et un ensemble de plaques support en aluminium 103, de type éléments radiateurs, sont fabriqués. Les éléments radiateurs 103 sont ensuite assemblés sur une première face du flexboard 102.

Dans une étape suivante, les leds 100 sont à leur tour fixées sur une deuxième face du flexboard 102, chaque led 100 étant positionnée de telle sorte qu'un élément radiateur 103 lui soit directement associé, le positionnement de chaque led étant parfaitement connu par rapport à la géométrie de chaque radiateur, les éléments radiateurs et les leds étant disposés de part et d'autre du flexboard. Une fois que le flexboard est équipé des éléments radiateurs et des leds, on dispose d'un flexboard dit équipé.

Dans le même temps, on réalise une pièce plastique intermédiaire 104, sur laquelle le flexboard équipé est assemblé par une opération de bouterollage. L'opération de bouterollage est réalisée en introduisant un ensemble de pions de fixation 105, réalisés sur la pièce plastique intermédiaire 104, à travers le flexboard et des orifices ménagés dans chaque élément radiateur, puis à bouteroller lesdits pions de fixation de façon à fixer le flexboard équipé sur la pièce plastique intermédiaire.

Les inconvénients d'un tel procédé de fixation sont les suivants :

Tout d'abord, il est nécessaire, dans un tel procédé, de faire intervenir la pièce plastique intermédiaire 104 ; en effet, une telle pièce est nécessaire pour maintenir le flexboard 102 équipé et pour pouvoir le présenter en regard de la pièce optique pour le fixer dessus, par exemple par une opération de clippage. Sans la présence de la pièce plastique intermédiaire 104, il faudrait disposer les pions de fixation directement sur le réflecteur 101, et donc venir bouteroller le flexboard équipé directement sur le réflecteur 101. Or l'opération de bouterollage impose une contre-réaction importante, contre-réaction qui serait alors supportée par le réflecteur 101 lui-même, ce qui ne manquerait pas de l'endommager, provoquant déformation et rayures notamment au niveau des parties métallisées du réflecteur 101. La présence d'une pièce plastique intermédiaire 104 est donc indispensable pour réaliser l'opération de bouterollage sans endommager le réflecteur. Mais cette pièce supplémentaire augmente le coût de fabrication, et rend le dispositif projecteur final moins compact du fait de sa seule présence.

Ensuite, le positionnement des leds 100 sur la pièce plastique supplémentaire 104 engendre mécaniquement une perte de précision dans le positionnement de ces mêmes leds 100 au sein des différents réflecteurs : en effet, les leds n'étant pas chacune disposée sur un support indépendant, il est impossible de recentrer chaque led individuellement par rapport à la partie du réflecteur qui lui est associée. Une telle imprécision de positionnement se traduit par une perte du flux lumineux généré par les diodes, perte de flux qui ne peut alors être compensée que par un ajout de diodes, ce qui entraîne, là encore, un surcoût de fabrication.

### DESCRIPTION GENERALE DE L'INVENTION

L'objet de l'invention propose une solution aux problèmes et inconvénients qui viennent d'être exposés. D'une façon générale, l'invention propose l'utilisation d'éléments supports, notamment d'éléments radiateurs, réalisés non plus en aluminium, comme c'est le cas dans l'état de la technique, mais en un matériau ductile, par exemple du cuivre, de l'inox, un alliage de cuivre ou autre. Par matériau ductile, on désigne un matériau dont la forme est modifiable, qui se laisse déformer sans rompre, tel qu'un matériau élastique. On propose alors, toujours selon l'invention, un procédé de fixation d'un support électronique flexible, supportant au moins une diode électroluminescente, sur une pièce optique tridimensionnelle, simplifié et moins coûteux par rapport aux procédés proposés dans l'état de la technique, dans la mesure où le procédé selon l'invention ne requiert pas la présence d'une pièce plastique intermédiaire dans sa mise en oeuvre.

A cet effet, dans l'invention, on prévoit notamment de ménager des ouvertures dans les éléments radiateurs réalisés dans un matériau ductile, les dites ouvertures étant destinées à recevoir et à maintenir, notamment après une légère déformation d'un pourtour des ouvertures ménagées dans les éléments radiateurs, des pions de fixation réalisés directement sur la pièce optique. Le procédé profite notamment du fait qu'une opération de bouterollage des pions de fixation sur les éléments radiateurs n'est plus indispensable. En effet, le caractère ductile du matériau utilisé pour la fabrication des éléments radiateurs présente notamment deux avantages :
- il rend inutile l'opération, précédemment décrite et nécessaire, de bouterollage, le maintien des pions de fixation étant directement assuré par le pourtour, après légère déformation lors de l'opération d'introduction des pions de fixation, des ouvertures ménagées dans le matériau ductile ;
- il permet, grâce à sa facile déformation, de limiter la contre-réaction nécessaire lors de l'introduction des pions de fixations dans les ouvertures appropriées des éléments radiateurs ; les pions de fixation peuvent ainsi être directement réalisés sur la pièce optique, ce qui permet de s'affranchir de la présence d'une pièce plastique intermédiaire.

L'invention concerne donc essentiellement un procédé de fixation d'un support électronique flexible sur une pièce optique tridimensionnelle, au moins une diode électroluminescente étant disposée sur ledit support électronique flexible, chaque diode électroluminescente étant associée à un élément support, par exemple un élément radiateur, caractérisé en ce que le procédé comporte notamment les différentes étapes consistant à :
- équiper la pièce optique tridimensionnelle d'un ensemble de pions de fixation ;
- fabriquer chaque élément support dans un matériau ductile, l'étape de fabrication de chaque élément support comportant notamment l'opération consistant à ménager au moins une première ouverture destinée à recevoir et à maintenir un des pions de fixation de la pièce optique tridimensionnelle ;
- assembler chaque élément support sur le support électronique flexible et chaque diode électroluminescente sur le support électronique flexible pour constituer un support électronique flexible équipé;
- assembler le support électronique flexible équipé et la pièce optique en introduisant chaque pion de fixation dans l'ouverture de l'élément support qui lui est destinée.

Le procédé selon l'invention peut comporter, en plus des caractéristiques principales qui viennent d'être mentionnées dans le paragraphe précédent, une ou plusieurs caractéristiques supplémentaires parmi les suivantes:
- les éléments supports et les diodes qui leur sont associées sont disposées de part et d'autre du support électronique flexible ;
- l'étape de fabrication de chaque élément support comporte l'opération consistant à ménager, en plus de la première ouverture, une seconde ouverture destinée à au moins recevoir un des pions de fixation de la pièce optique tridimensionnelle ;
- la première ouverture présente au moins une languette de rétention pour maintenir, après déformation, le pion de fixation qui lui est destiné ;
- la seconde ouverture présente au moins une languette de rétention pour maintenir, après déformation, le pion de fixation qui lui est destiné ;
- chaque languette de rétention présente une extrémité libre qui crée un relief au niveau de l'ouverture présentant la languette considérée ;
- l'étape d'introduction des pions de fixations dans les ouvertures qui leur sont destinées est réalisée en introduisant les pions d'un côté de l'ouverture où les languettes de rétention ne créent pas de relief ;
- le matériau ductile utilisé dans l'étape de fabrication des éléments supports est du cuivre, ou de l'inox, ou un alliage à base de cuivre.

La présente invention se rapporte également à un élément radiateur apte à être utilisé dans le procédé, selon l'invention, de fixation d'un support électronique flexible sur une pièce optique tridimensionnelle, ledit élément radiateur étant associé à une diode électroluminescente pour évacuer une énergie thermique produite par la diode électroluminescente considérée, l'élément radiateur étant réalisé dans un matériau ductile, caractérisé en ce qu'il comporte au moins une première ouverture pour recevoir et maintenir un premier pion de fixation équipant la pièce optique tridimensionnelle, et en ce que la première ouverture présente au moins une languette de rétention pour maintenir, après déformation, le pion de fixation qui lui est destiné.

L'invention et ses différentes applications seront mieux comprises à la lecture de la description qui suit et à l'examen des figures qui l'accompagnent.

### BREVE DESCRIPTION DES FIGURES

Celles-ci ne sont présentées qu'à titre indicatif et nullement limitatif de l'invention. Les figures montrent :
- à la figure 1, déjà décrite, un exemple d'élément pour dispositif projecteur illustrant la fixation d'un support électronique flexible sur une pièce optique tridimensionnelle selon un procédé de l'état de la technique;
- à la figure 2, un élément de dispositif projecteur résultant de la fixation d'un support électronique flexible sur une pièce optique tridimensionnelle selon un exemple de mise en oeuvre du procédé selon l'invention;
- à la figure 3, un exemple d'élément support utilisé dans le procédé selon l'invention;
- à la figure 4, un exemple d'une ouverture ménagée dans un élément support du type de celui montré à la figure 3 ;
- à la figure 5, une illustration détaillée d'une étape particulière d'un exemple de mise en oeuvre du procédé selon l'invention.

### DESCRIPTION DES FORMES DE REALISATION PREFEREES DE L'INVENTION

Les différents éléments apparaissant sur plusieurs figures auront gardé, sauf précision contraire, la même référence.

La figure 2 montre de façon schématique une coupe d'un élément optique, destiné à être positionné dans un dispositif projecteur, ledit élément optique résultant de la fixation d'un support électronique flexible 200 équipé de diodes électroluminescentes 201 sur un réflecteur 202 constituant un environnement tridimensionnel, dans la mesure où il comporte plusieurs plans de support de sources lumineuses.

Le procédé de fixation selon l'invention permettant d'obtenir l'élément optique montré en coupe à la figure 2 est le suivant :

Dans un premier temps, le flexboard 200 et un ensemble de plaques support 203, par exemple de type éléments radiateurs, sont fabriqués. Les éléments radiateurs 203 sont fabriqués dans un matériau ductile, par exemple du cuivre. Les éléments radiateurs 203 sont ensuite assemblés sur une première face du flexboard 200. Dans la fabrication de chaque élément radiateur 203, on prévoit de ménager des ouvertures, parmi lesquelles au moins une première ouverture 300, visible aux figures 3 à 5, destinée à recevoir un pion de fixation 204 pointant au niveau d'une face arrière du réflecteur ou d'une autre pièce optique 202.

Dans une étape suivante, les leds 201 sont à leur tour fixées sur une deuxième face du flexboard 200, chaque led 201 étant positionnée de telle sorte qu'un élément radiateur 203 lui soit directement associé, le positionnement de chaque led sur le flexboard 200 étant parfaitement connu par rapport à celui d'un des éléments radiateurs, les éléments radiateurs et les leds étant disposés de part et d'autre du flexboard. Une fois que le flexboard est équipé des éléments radiateurs et des leds, on dispose d'un flexboard dit équipé.

On peut alors procéder à l'assemblage du flexboard équipé et du réflecteur ou de toute autre pièce optique 202 en introduisant dans chaque ouverture ménagée dans les éléments radiateurs 203 un des pions de fixation 204 du réflecteur ou de toute autre pièce optique 202.

Dans un mode de réalisation avantageux, la première ouverture 300 est caractérisée par une forme globalement circulaire, avec un pourtour présentant une pluralité de languettes de rétention 301. Elle constitue ainsi un élément connu par l'homme du métier sous le nom d'agrippine (ou sous le vocable anglo-saxon « crimping »); à noter qu'une ouverture ne présentant qu'une unique languette de rétention 301 constitue également une agrippine. Par exemple, les languettes de rétention sont disposées sur la totalité du pourtour de la première ouverture. Chaque languette de rétention 301 est caractérisée par une base 302, directement rattachée à l'élément radiateur 203, et par une extrémité libre 303, orientée vers la partie centrale de la première ouverture 300. Ainsi, lors de l'étape d'introduction d'un des pions de fixation 204 dans la première ouverture 300, chaque languette de rétention 301 peut légèrement se déformer dans le sens du mouvement d'introduction, les extrémités libres 303 de chaque languette de rétention 301 accompagnant alors le pion de fixation 204 dans son évolution.

La pluralité des languettes de rétention 301 de la première ouverture 300 permet de maintenir au mieux le pion de fixation 204 dans la première ouverture 300 : le caractère ductile du matériau employé pour réaliser l'élément radiateur 203, et donc pour réaliser les languettes de rétention 301, présente cet avantage supplémentaire de gêner un mouvement inverse au mouvement d'introduction du pion de fixation 204 dans la première ouverture 300. Cette avantage supplémentaire se vérifie de façon encore plus évidente lorsque les languettes de rétention 301 forment un relief, visible aux figures 4 et 5, les extrémités libres 303 sortant légèrement, dans une direction d'introduction du pion de fixation 204 symbolisée par une flèche 500 visible à la figure 5, d'un plan défini par l'épaisseur de l'élément radiateur 203.

Dans un mode de réalisation avantageux, chaque élément radiateur 203 présente une seconde ouverture 304, visible à la figure 3. La seconde ouverture est également destinée à recevoir un pion de fixation 204 pointant aussi au niveau de la face arrière du réflecteur 202. La fonction principale de la seconde ouverture 304 est de recevoir un des pions de fixation 204 pour prévenir toute rotation de l'élément radiateur 203. En conséquence, la présence de languettes de rétention 301 est moins importante pour la seconde ouverture 304 que pour la première ouverture 300. On peut par exemple se contenter, comme dans l'exemple montré à la figure 3, d'une unique languette de rétention 301, qui sert alors à combler un jeu qui pourrait exister entre le pion de fixation 204 et la seconde ouverture 304 si elle ne présentait pas de telle languette de rétention.

Les formes des agrippines décrites dans les exemples précédents ne sont pas limitatives. La forme des agrippines peut notamment varier en fonction du matériau utilisé pour fabriquer les éléments radiateurs 203. Le nombre de languettes peut varier ; la forme des agrippines n'est pas nécessairement symétrique ; les dimensions des ouvertures 300 et/ou 304 dépendent notamment des dimensions des pions de fixation 204 et du matériau dans lequel ils sont constitués ; les pions de fixation 204 peuvent être de forme globalement cylindrique, mais ce n'est pas une obligation, une forme de section carrée, rectangulaire ou autre peut être tout particulièrement adapté à différentes situations ; l'épaisseur des éléments radiateurs 203 est fonction du type de diode utilisée, et notamment de sa puissance radiative.

Les avantages d'un tel procédé de fixation sont les suivants :
- avantage photométrique du fait que les diodes électroluminescentes sont montées directement sur la pièce optique, sans pièce plastique intermédiaire ; la position de chaque led par rapport à la partie du réflecteur ou de la pièce optique où elle doit être placée est ainsi plus précise, car chaque led est associée à un élément radiateur indépendant ; elle garde ainsi une liberté de mouvement qui permet de la recentrer individuellement, sans provoquer de déplacement pour les autres leds ;
- avantage financier du fait de la suppression d'une pièce plastique intermédiaire dans le procédé de fixation, et du fait de la réduction du nombre de leds nécessaires pour obtenir un flux donné, grâce à une optimisation du placement de chacune des leds au sein du réflecteur ou de la pièce optique;
- avantage esthétique : le dispositif projecteur complet peut être plus compact que dans l'état de la technique, au moins une pièce - la pièce plastique intermédiaire - ayant été supprimée.

Parmi les diodes électroluminescentes qui peuvent intervenir dans le procédé selon l'invention, ou être associées avec les éléments radiateurs selon l'invention, on peut citer par exemple celles qui sont connues par l'homme du métier sous les noms commerciaux de smartled, power topled, advance power topled, dragon led, piranha, luxeon... (marques déposées).

## Revendications

1. Procédé de fixation d'un support électronique flexible (200) sur une pièce optique tridimensionnelle (202), au moins une diode électroluminescente (201) étant disposée sur ledit support électronique flexible, chaque diode électroluminescente étant associée à un élément support (203), par exemple un élément radiateur, **caractérisé en ce que** le procédé comporte notamment les différentes étapes consistant à :
- équiper la pièce optique tridimensionnelle (202) d'un ensemble de pions de fixation (204);
- fabriquer chaque élément support (203) dans un matériau ductile, l'étape de fabrication de chaque élément support (203) comportant notamment l'opération consistant à ménager au moins une première ouverture (300) destinée à recevoir et à maintenir un des pions de fixation (204) de la pièce optique tridimensionnelle (202) ;
- assembler chaque élément support (203) sur le support électronique flexible (200) et chaque diode électroluminescente (201) sur le support électronique flexible (200) pour constituer un support électronique flexible équipé;
- assembler le support électronique flexible (200) équipé et la pièce optique ridimensionnelle (202) en introduisant chaque pion de fixation (204) dans l'ouverture (300) de l'élément support qui lui est destinée.

2. Procédé selon la revendication précédente **caractérisé en ce que** les éléments supports (203) et les diodes (201) qui leur sont associées sont disposées de part et d'autre du support électronique flexible (200).

3. Procédé selon l'une au moins des revendications précédentes **caractérisé en ce que** l'étape de fabrication de chaque élément support (203) comporte l'opération consistant à ménager, en plus de la première ouverture (300), une seconde ouverture (304) destinée à au moins recevoir un des pions de fixation (204) de la pièce optique tridimensionnelle. (202)

4. Procédé selon l'une au moins des revendications précédentes **caractérisé en ce que** la première ouverture présente au moins une languette de rétention (301) pour maintenir, après déformation, le pion de fixation (204) gui lui est destiné.

5. Procédé selon la revendication 3 **caracténsé en ce que** la seconde ouverture présente au moins une languette de rétention (301) pour maintenir, après déformation, le pion de fixation (204) qui lui est destiné.

6. Procédé selon l'une au moins des revendications 4 ou 5 **caractérisé en ce que** chaque languette de rétention (301) présente une extrémité libre (303) qui crée un relief au niveau de l'ouverture présentant la languette considérée.

7. Procédé selon la revendication précédente **caractérisé en ce que** l'étape d'introduction des pions de fixations (204) dans les ouvertures (300, 304) qui leur sont destinés est réalisée en introduisant les pions (204) d'un côté de l'ouverture où les languettes de rétention ne créent pas de relief.

8. Procédé selon l'une au moins des revendications précédentes **caractérisé en ce que** le matériau ductile utilisé dans l'étape de fabrication des éléments supports (203) est du cuivre, ou de l'inox, ou un alliage à base de cuivre.

9. Elément radiateur (203) apte à être utilisé dans le procédé, selon l'une au moins des revendications précédentes, de fixation d'un support électronique flexible (200) sur une pièce optique tridimensionnelle (202), ledit élément radiateur étant associé à une diode électroluminescente (201) pour évacuer une énergie thermique produite par la diode électroluminescente considérée, l'élément radiateur étant réalisé dans un matériau ductile, **caractérisé en ce qu'**il comporte au moins une première ouverture (300) pour recevoir et maintenir un premier pion de fixation (204) équipant la pièce optique tridimensionnelle, et **en ce que** la première ouverture présente au moins une languette de rétention (301) pour maintenir, après déformation, le pion de fixation qui lui est destiné.

10. Elément radiateur (203) selon la revendication précédente **caractérisé en ce qu'**il comporte une seconde ouverture (304) destinée à au moins recevoir un second pion de fixation de la pièce optique tridimensionnelle (202).

11. Elément radiateur (203) selon la revendication 10 **caractérisé en ce que** la seconde ouverture (304) présente au moins une languette de rétention (301) pour maintenir, après déformation, le pion de fixation qui lui est destiné.

12. Elément radiateur (203) selon l'une au moins des revendications 9 ou 11 **caractérisé en ce que** chaque languette de rétention (301) présente une extrémité libre (303) qui crée un relief au niveau de l'ouverture présentant la languette considérée.

13. Elément radiateur (203) selon l'une au moins des revendications 9 à 12 **caractérisé en ce que** le matériau ductile est du cuivre, ou de l'inox, ou un alliage à base de cuivre.

## Claims

1. Method for securing a flexible electronic support (200) onto a three-dimensional optical part (202), at least one electroluminescent diode (201) being disposed on the said flexible electronic support, each electroluminescent diode being associated with a support element (203), for example a radiator element, **characterised in that** the method comprises in particular the different steps consisting of:
- equipping the three-dimensional optical part (202) with a series of securing pins (204);
- producing each support element (203) from a ductile material, the step of production of each support element (203) comprising in particular the operation consisting of providing at least one first opening (300) which is designed to receive and retain one of the securing pins (204) of the three-dimensional optical part (202);
- assembling each support element (203) on the flexible electronic support (200) and each electroluminescent diode (201) on the flexible electronic support (200) in order to constitute an equipped flexible electronic support; and
- assembling the equipped flexible electronic support (200) and the three-dimensional optical part (202) by introducing each securing pin (204) into the opening (300) in the support element which is destined for it.

2. Method according to the preceding claim, **characterised in that** the support elements (203) and the diodes (201) which are associated with them are disposed on both parts of the flexible electronic support (200).

3. Method according to at least one of the preceding claims, **characterised in that** the step of production of each support element (203) comprises the operation consisting of providing, in addition to the first opening (300), a second opening (304) which is designed at least to receive one of the securing pins (204) of the three-dimensional optical part (202).

4. Method according to at least one of the preceding claims, **characterised in that** the first opening has at least one retention tongue (301) in order to retain the securing pin (204) which is destined for it, after deformation.

5. Method according to claim 3, **characterised in that** the second opening has at least one retention tongue (301) in order to retain the securing pin (204) which is destined for it, after deformation.

6. Method according to at least one of claims 4 or 5, **characterised in that** each retention tongue (301) has a free end (303) which creates a relief at the level of the opening which has the tongue concerned.

7. Method according to the preceding claim, **characterised in that** the step of introduction of the securing pins (204) into the openings (300, 304) which are destined for them is carried out by introducing the pins (204) on a side of the opening where the retention tongues do not create a relief.

8. Method according to at least one of the preceding claims, **characterised in that** the ductile material used in the step of production of the support elements (203) is copper, or stainless steel, or a copper-based alloy.

9. Radiator element (203) which can be used in the method according to at least one of the preceding claims, for securing a flexible electronic support (200) onto a three-dimensional optical part (202), the said radiator element being associated with an electroluminescent diode (201) in order to discharge thermal energy produced by the electroluminescent diode concerned, the radiator element being produced from a ductile material, **characterised in that** it comprises at least a first opening (300) in order to receive and retain a first securing pin (204) which equips the three-dimensional optical part, and **in that** the first opening has at least one retention tongue (301) in order to retain the securing pin which is destined for it, after deformation.

10. Radiator element (203) according to the preceding claim, **characterised in that** it comprises a second opening (304) which is designed at least to receive a second securing pin for the three-dimensional optical part (202).

11. Radiator element (203) according to claim 10, **characterised in that** the second opening (304) has at least one retention tongue (301) to retain the securing pin which is destined for it, after deformation.

12. Radiator element (203) according to at least one of claims 9 or 11, **characterised in that** each retention element (301) has a free end (303) which creates a relief at the level of the opening which has the tongue concerned.

13. Radiator element (203) according to at least one of claims 9 to 12, **characterised in that** the ductile material is copper, or stainless steel, or a copper-based alloy.

## Patentansprüche

1. Verfahren zum Befestigen einer flexiblen Leiterplatte (200) auf einem dreidimensionalen optischen Bauteil (202), wobei wenigstens eine Leuchtdiode (201) auf der flexiblen Leiterplatte angeordnet ist, wobei jede Leuchtdiode einem Trägerelement (203) zugeordnet ist, zum Beispiel einem wärmeableitenden Element, **dadurch gekennzeichnet, dass** das Verfahren insbesondere die unterschiedlichen Schritte umfasst, die bestehen aus:
- Ausrüsten des dreidimensionalen optischen Bauteils (202) mit einem Satz Befestigungsstifte (204);
- Herstellen jedes Trägerelements (203) aus einem duktilen Werkstoff, wobei der Schritt zur Herstellung eines jeden Trägerelements (203) insbesondere das Ausbilden wenigstens einer ersten Öffnung (300) umfasst, die zur Aufnahme und zum Halten eines der Befestigungsstifte (204) des dreidimensionalen optischen Bauteils (202) bestimmt ist;
- Montieren jedes Trägerelements (203) auf der flexiblen Leiterplatte (200) und jeder Leuchtdiode (201) auf der flexiblen Leiterplatte (200), um eine bestückte flexible Leiterplatte zu bilden;
- Verbinden der bestückten flexiblen Leiterplatte (200) und des dreidimensionalen optischen Bauteils (202) miteinander, wobei jeder Befestigungsstift (204) in die ihm zugedachte Öffnung (300) des Trägerelements eingeführt wird.

2. Verfahren nach dem vorhergehenden Anspruch,
**dadurch gekennzeichnet, dass** die Trägerelemente (203) und die diesen zugeordneten Dioden (201) auf beiden Seiten der flexiblen Leiterplatte (200) angeordnet sind.

3. Verfahren nach wenigstens einem der vorhergehenden Ansprüche,
**dadurch gekennzeichnet, dass** der Schritt zur Herstellung eines jeden Trägerelements (203) zusätzlich zur ersten Öffnung (300) das Ausbilden einer zweiten Öffnung (304) umfasst, die zur Aufnahme wenigstens eines der Befestigungsstifte (204) des dreidimensionalen optischen Bauteils (202) bestimmt ist.

4. Verfahren nach wenigstens einem der vorhergehenden Ansprüche,
**dadurch gekennzeichnet, dass** die erste Öffnung wenigstens eine Haltelasche (301) aufweist, um nach Verformung den ihr zugedachten Befestigungsstift (204) zu halten.

5. Verfahren nach Anspruch 3,
**dadurch gekennzeichnet, dass** die zweite Öffnung wenigstens eine Haltelasche (301) aufweist, um nach Verformung den ihr zugedachten Befestigungsstift (204) zu halten.

6. Verfahren nach wenigstens einem der Ansprüche 4 oder 5,
**dadurch gekennzeichnet, dass** jede Haltelasche (301) ein freies Ende (303) aufweist, das in Höhe der die betreffende Lasche aufweisenden Öffnung ein Profil bildet.

7. Verfahren nach dem vorhergehenden Anspruch,
**dadurch gekennzeichnet, dass** der Schritt zum Einführen der Befestigungsstifte (204) in die ihr zugedachten Öffnungen (300, 304) **dadurch** erfolgt, dass die Stifte (204) an einer Seite der Öffnung eingeführt werden, an der die Haltelaschen kein Profil bilden.

8. Verfahren nach wenigstens einem der vorhergehenden Ansprüche,
**dadurch gekennzeichnet, dass** der bei dem Schritt zur Herstellung der Trägerelemente (203) verwendete duktile Werkstoff Kupfer oder Edelstahl oder eine Legierung auf Kupferbasis ist.

9. Wärmeableitendes Element (203), das in dem Verfahren nach wenigstens einem der vorhergehenden Ansprüche verwendet zu werden vermag, zum Befestigen einer flexiblen Leiterplatte (200) auf einem dreidimensionalen optischen Bauteil (202), wobei das wärmeableitende Element einer Leuchtdiode (201) zugeordnet ist, um eine durch die betreffende Leuchtdiode erzeugte Wärmeenergie abzuleiten, wobei das wärmeableitende Elemente aus einem duktilen Werkstoff hergestellt ist,
**dadurch gekennzeichnet, dass** es wenigstens eine erste Öffnung (300) zur Aufnahme und zum Halten eines ersten Befestigungsstifts (204) aufweist, mit dem das dreidimensionale optische Bauteil ausgestattet ist, und dass die erste Öffnung wenigstens eine Haltelasche (301) aufweist, um nach Verformung den ihr zugedachten Befestigungsstift zu halten.

10. Wärmeableitendes Element (203) nach dem vorhergehenden Anspruch,
**dadurch gekennzeichnet, dass** es eine zweite Öffnung (304) aufweist, die zumindest zur Aufnahme eines zweiten Befestigungsstifts des dreidimensionalen optischen Bauteils (202) bestimmt ist.

11. Wärmeableitendes Element (203) nach Anspruch 10,
**dadurch gekennzeichnet, dass** die zweite Öffnung (304) wenigstens eine Haltelasche (301) aufweist, um nach Verformung den ihr zugedachten Befestigungsstift zu halten.

12. Wärmeableitendes Element (203) nach wenigstens einem der Ansprüche 9 oder 11,
**dadurch gekennzeichnet, dass** jede Haltelasche (301) ein freies Ende (303) aufweist, das in Höhe der Öffnung, welche die betreffende Lasche aufweist, ein Profil bildet.

13. Wärmeableitendes Element (203) nach wenigstens einem der Ansprüche 9 bis 12,
**dadurch gekennzeichnet, dass** der duktile Werkstoff Kupfer oder Edelstahl oder eine Legierung auf Kupferbasis ist.
